# EUROPEAN PATENT SPECIFICATION

(11) **EP 3 783 646 B1**
(45) Date of publication and mention of the grant of the patent: **01.04.2026**
(21) Application number: 20188658.7
(22) Date of filing: 30.07.2020
(51) Int. Cl.: H10W 20/40, H10W 20/42, H10W 44/00, H10W 70/40, H10D 86/00

(54) **SINGLE CHIP SIGNAL ISOLATOR**
EINZELCHIP-SIGNALISOLATOR
ISOLATEUR DE SIGNAL À PUCE UNIQUE

(30) Priority: 22.08.2019 US 201916547823
(43) Date of publication of application: 24.02.2021
(73) Proprietor: Allegro MicroSystems, LLC, Manchester, NH 03103-3353 (US)
(72) Inventor: BRIANO, Robert A., Auburn, 31 03032 (US); UBERTI, Bruno Luis, C1425 Ciudad Autonoma de Buenos Aires (AR); MILESI, Alejandro Gabriel, 1636 Buenos Aires (AR); MONREAL, Gerardo A., 1631 Buenos Aires (AR)
(74) Representative: South, Nicholas Geoffrey

(56) References cited:
- EP-A1- 1 089 337
- EP-A1- 2 674 975
- EP-A1- 3 293 889
- EP-A1- 3 748 863
- EP-A1- 3 779 478
- EP-A2- 1 180 800
- WO-A1-2012/065229
- WO-A1-2014/036594
- JP-A- 2001 036 012
- JP-A- 2006 115 455
- JP-A- 2006 279 063
- US-A1- 2002 117 750
- US-A1- 2008 218 258
- US-A1- 2014 264 722
- US-A1- 2015 061 070
- US-A1- 2016 080 181

## Description

### BACKGROUND

As is known in the art, signal isolators can be used to transfer information across a barrier used to separate two or more voltage domains for safety or functional isolation. For example, capacitive coupling can be used to transfer information across a barrier. Optocouplers include a LED that emits light through an optically transparent insulating film and strikes a photo detector that generates a current flow that corresponds to the emitted light. RF carriers can also be used to transmit information across an isolation barrier.

US 2002/117750 A1 relates to a semiconductor device having an imbedded insulating layer is formed in a semiconductor substrate. A plurality of electric circuits are formed on the imbedded insulating layer so as to be insulated each other, and are capacitively coupled through the semiconductor substrate. Wiring layers are formed on the electric circuits, and include inside electrodes which are capacitively coupled to the electric circuits. The electric circuits are connected through capacitors which are formed through the semiconductor substrate, and through capacitors which are formed through the electrodes.

JP 2006 279063 A relates to an isolator made to be monolithic by using an SOI or DI substrate as region separating means of the monolithic isolator and forming a high breakdown voltage insulating barrier using an insulating band or an interlayer insulating film. Insulating breakdown voltage of a first side and a second side is secured using an SOI embedding oxide film, trench insulating films, and an interlayer insulating film comprising LOCOS. The insulating breakdown voltage of a capacitor for carrying out signal transfer is secured using interlayer insulating films comprising LOCOS between diffusion layers and a metal layer.

JP 2006 115455 A relates to an interface circuit in which integrated circuits are connected to each other via a transmission line and a data signal is transmitted and received via a single transmission line. Between the transmission line and the power source, an impedance device configured to change the termination impedance is provided.

EP 2 674 975 A1 relates to circuitry for the isolation and communication of signals between circuits operating in different voltage domains using capacitive coupling. The capacitive coupling is provided by one or more capacitive structures having a breakdown voltage that is defined by way of the various components and their spacing. The capacitive structures each include three capacitive plates arranged to have two plates located in an upper layer and one plate located in a lower layer. A communication signal can be transmitted via the capacitive coupling created between the lower plate and each of the upper plates, respectively.

### SUMMARY

The present invention provides a signal isolator IC package as recited in claim 1 and a method as recited in claim 2.

A signal isolator IC package can include one or more of the following features: the die comprises a single die processed to provide the first and second die portions, the first signal path is bi-directional, the first and second die portions are separated by a trench filled with insulative material, the first path includes first and second capacitors having a common plate, the first capacitor comprises first and second plates separated by a first dielectric layer, and the second capacitor comprises a third plate and the second plate, the second plate overlaps the first plate and the third plate, the first dielectric layer separates the first plate and the second plate, the first and second die portions are separated on respective four lateral sides by a trench filled with insulating material, the first signal path includes coils to provide isolated inductive coupling of the first and second die portions, active circuit devices are not placed within a keep-out area, where the first path includes first and second capacitors having a common plate, and wherein the first capacitor comprises first and second plates separated by a first dielectric layer, and the second capacitor comprises a third plate and the second plate, wherein the keep-out area is defined by the second plate, the first signal path is configured for On-Off keying (OOK) modulation, the first die portion includes a safe-state module to detect a lack of carrier signal, and/or the safe-state module transitions one or more output pins of the IC package to a high impedance state upon detection of an error condition.

A method can include one or more of the following features: the die comprises a single die processed to provide the first and second die portions, the first signal path is bi-directional, the first and second die portions are separated by a trench filled with insulative material, the first path includes first and second capacitors having a common plate, the first capacitor comprises first and second plates separated by a first dielectric layer, and the second capacitor comprises a third plate and the second plate, the second plate overlaps the first plate and the third plate, the first dielectric layer separates the first plate and the second plate, the first and second die portions are separated on respective four lateral sides by a trench filled with insulating material, the first signal path includes coils to provide isolated inductive coupling of the first and second die portions, active circuit devices are not placed within a keep-out area, where the first path includes first and second capacitors having a common plate, and wherein the first capacitor comprises first and second plates separated by a first dielectric layer, and the second capacitor comprises a third plate and the second plate, wherein the keep-out area is defined by the second plate, the first signal path is configured for On-Off keying (OOK) modulation, the first die portion includes a safe-state module to detect a lack of carrier signal, and/or the safe-state module transitions one or more output pins of the IC package to a high impedance state upon detection of an error condition.

### BRIEF DESCRIPTION OF THE DRAWINGS

The foregoing features of this invention, as well as the invention itself, may be more fully understood from the following description of the drawings in which:
FIG. 1 is a schematic representation of a signal isolator having a single chip ;
FIG. 2A shows layers in an example implementation of the single chip isolator of FIG. 1 in accordance with an example embodiment of the invention;
FIG. 2B is a top view of the isolator of FIG. 2A showing first and second voltage domains;
FIG. 2C is a top view of another embodiment of the isolator of FIG. 2A having multiple voltage domains;
FIG. 3 is a diagram showing additional detail for the isolator of FIG. 2A;
FIG. 4 is a schematic representation of an example isolator having a first and second die portions formed form a signal die;
FIG. 5 is a cutaway top view of a bonding diagram for an example single-chip isolator IC package; and
FIG. 6 is a schematic representation of an example computer that can perform at least a portion of the processing described herein.

### DETAILED DESCRIPTION

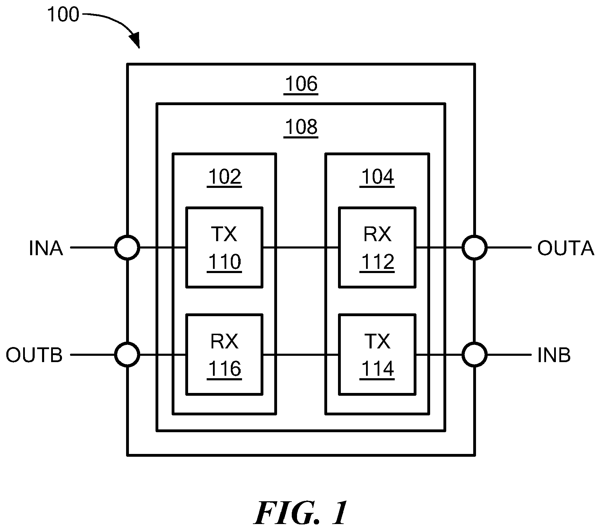

FIG. 1 shows an example of a single chip signal isolator 100 including isolated first and second die portions 102, 104 that form part of an integrated circuit package 106 in accordance with example embodiments of the invention. In embodiments, the first and second die portions 102, 104 are part of a single die and are isolated from each other. In an embodiment, the IC package 106 includes a first input signal INA connected to the first die portion 102 and a first output signal OUTA connected to the second die portion 104. The IC package 106 further includes a second input signal INB connected to the second die portion 104 and a second output signal OUTB to the first die portion 104. The first and second die portions 102, 104 are separated by a barrier region 108, such as an isolation barrier.

In embodiments, the first die portion 102 includes a first transmit module 110 and the second die portion 104 includes a first receive module 112 that provides a signal path from the first input signal INA to the first output signal OUTA across the barrier 108. The second die portion 104 includes a second transmit module 114 and the first die portion 104 includes a second receive module 116 that provides a signal path from the second input signal INB to the second output signal OUTB across the barrier 108.

It is understood that any practical number of transmit, receive, and transmit/receive modules can be formed on the first and/or second die portions to meet the needs of a particular application. It is further understood that transmit, receive, and transmit/receive modules can comprise the same or different components. In addition, in embodiments, bi-directional communication is provided across the barrier. Further, circuity in the first and/or second die portions can be provided to process signals, perform routing of signals, and the like. In some embodiments, sensing elements are formed in, on, or about the first and/or second die.

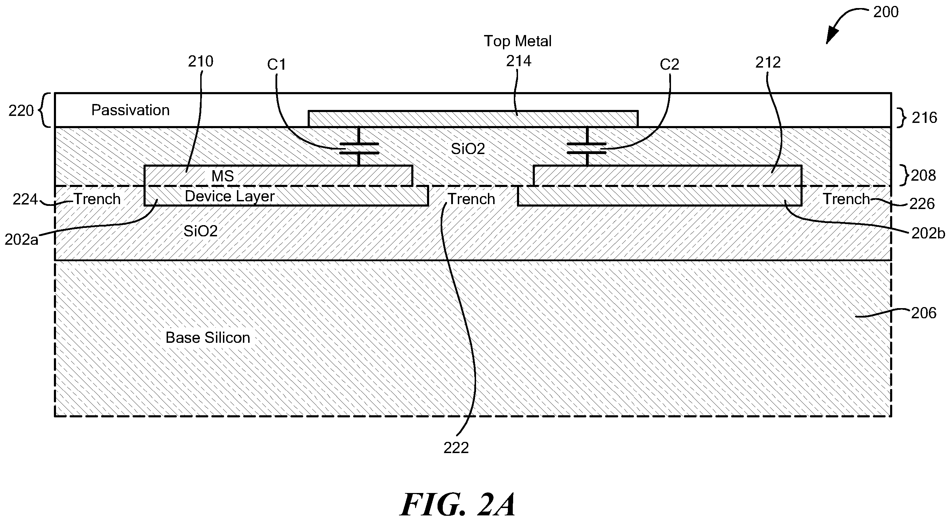

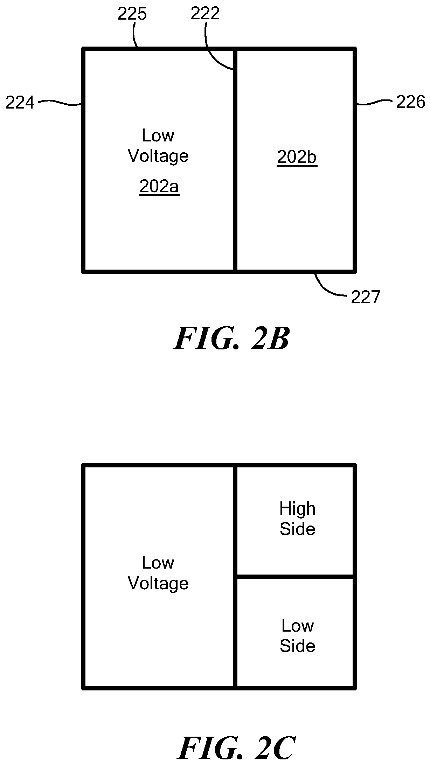

FIGs. 2A and 2B show an example IC package signal isolator 200 in accordance with the invention having a first die portion 202a and a second die portion 202b formed from a single die, wherein the first and second die portions are electrically isolated from each other to provide two different voltage domains. In example embodiments, the first and second die portions 202a, 202b are each surrounded by insulative material. In the case of a rectangular die portions, the first and second die portions 202a,202b are surrounded on six sides by insulative material. A dielectric layer 204, such as SiO₂, is formed on a substrate 206, which can comprise silicon. The first and second die portions 202a, 202b can provide active layers in which circuitry can be formed to implement isolator functionality. Various layers can be added to the substrate to provide signal path(s) from the first die portion to the second die portion.

A first metal layer 208 incudes a first metal portion 210 and a second metal portion 212. A third metal portion 214 overlapping the first and second metal portions 210, 212 is formed in a second metal layer 216. The first and second metal layers 214, 216 are separated by a dielectric layer 218, such as SiO₂. A passivation and/or polymide layer 220 can be formed on top of the second metal layer 216.

A first insulating trench 222 is located between and isolates the first and second die portions 202a,b. Outer insulating trenches 224, 226 can be formed on the outer sides of the first and second die portions 202a,b. As can be seen in FIG. 2B, each of the first and second die portions 202a,b can have insulating trenches on the four sides. The first die portion 202a is surrounded by trenches 222, 224, 225, 227, and the second die portion 202b is surrounded by trenches 222, 225, 226, 227. The first and second die portions 202a,b are sandwiched in between dielectric layer 204 and dielectric layer 218. Thus, all six sides of the first and second die portions 202a,b are surrounded by insulating materials. In the illustrated embodiment, the first metal portion 210 and the third metal portion 214 form a first capacitor C1 and the second metal portion 212 and the third metal portion 214 for a second capacitor C2. The first and second capacitors C1, C2, which are coupled in series, provide an isolated capacitively coupled signal path between an active region of the first die portion 202a and an active region of the second die portion 202b. The two capacitors C1 and C2 form an in-series isolated path between the active regions. In other embodiments, a first capacitor C1 is formed with a first metal portion 210 and a third metal portion 214 would constitute a single-capacitor isolated path, where the third metal layer 214 is galvanically connected through conductive vias to the active region 202b. This arrangement provides better transmission coupling between the active regions 202a and 202b at the expense of a lower insulation voltage. It is understood that any number of metal-insulator-metal arrangements are possible to balance the requirements of signal coupling versus insulating voltage.

In other embodiment, the first metal portion 210 and the third metal portion 214 form a unique capacitor C1 to form the isolation of the first die portion 202a and the second die portion 202b.

In other embodiments, the first and second die portions 202a,b can have an isolated inductive path. For, example, a first coil can be provided in a first metal layer and a second coil overlapping with the first coil can be provided in a second metal layer.

In embodiments, the first die portion 202a provides a first voltage domain and the second die portion 202b provides a second voltage domain. For example, the first voltage domain can be typical digital circuit voltage levels and the second voltage domain can be a higher level voltage domain, such as 48V. It is understood that the potential difference between grounds of the first and second voltage domain can range from zero to hundreds or thousands of volts. According to the invention the first and second die portions 202a, 202b have separate voltage supply signals and separate ground connections.

It is understood that a die can be processed to have any practical number of isolated die portions, as shown in FIG. 2C. Each die portion can be surrounded by trenches and sandwiched by isolator layers to provide isolation on six sides. In example embodiments, the trenches are first etched to the buried oxide layer and then filled with SiO₂.

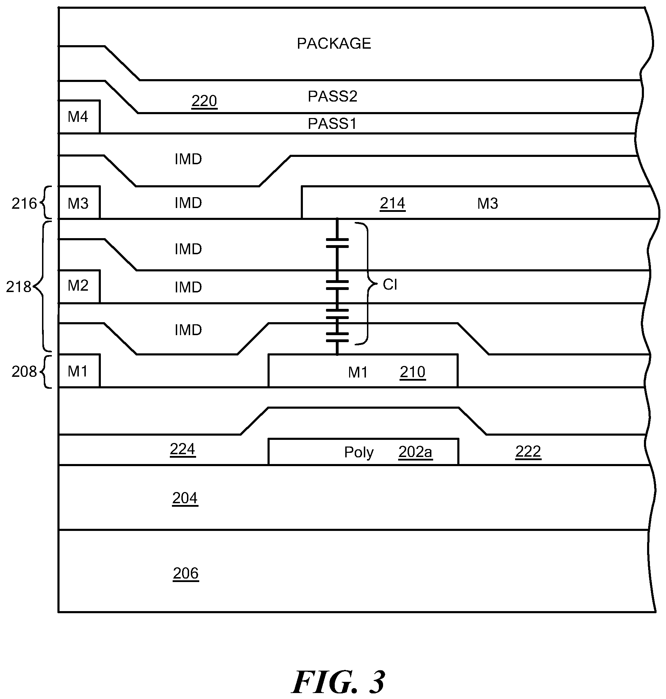

FIG. 3 shows an example stack up for the 'left' side of the isolator 200 embodiment shown in FIG. 2A wherein like reference numbers indicate like elements. The signal isolator 200 includes insulator 204, such as buried oxide, e.g., SiO₂, commonly known as BOX, on the silicon substrate 206 with the first die portion 202a providing active components in a device layer. Insulating material fills the trenches 222, 224 on each side of the first die portion 202a. The first metal region 210 is located above the first die portion 202a and under the third metal region 214. In the illustrated embodiment, a series of IMDs (InterMetallic Dielectric layers) form the dielectric layer 218 between the first and third metal regions 210, 214 that form the first capacitor C1. The IMD layers can comprise SiO₂ and/or silicon nitride, for example.

The SOI die can be attached to a leadframe paddle (not shown) with conductive die attach epoxy or film. In this case, the leadframe is electrically isolated from the active voltage domains through the insulating BOX. When the die is attached with a non-conductive die attach epoxy or film, the leadframe itself is "floating", that is, further insulated from the substrate. In either configuration the substrate is electrically isolated from all active voltage domains.

In the latter case, however, the insulation thickness of the SiO₂ layer 204 is effectively doubled since any electrical breakdown between the first and second voltage domains on the respective first and second die portions 202a,b will have to go down through the SiO2/BOX layer under one voltage domain and then up through the BOX/SiO2 in the other voltage domain.

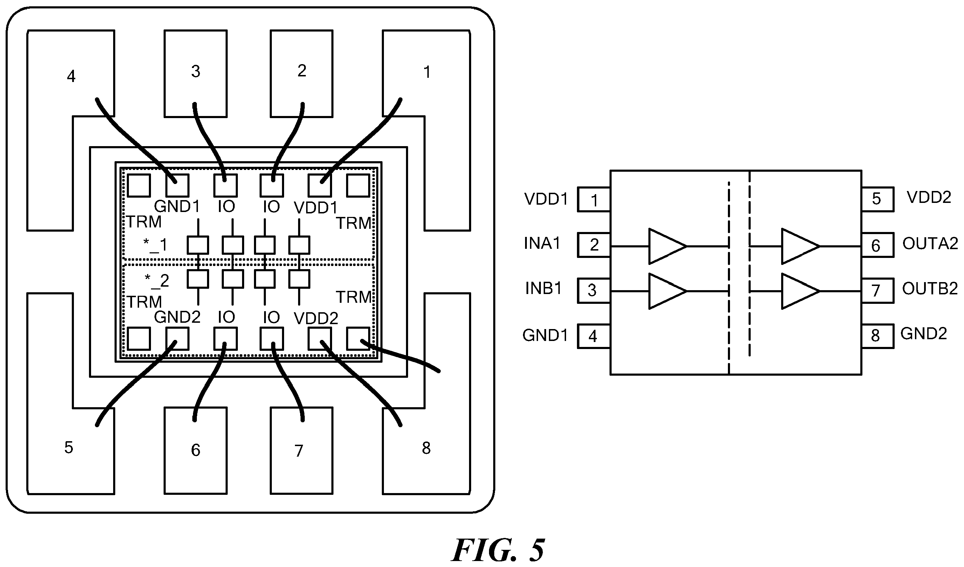

The die and leadframe assembly can be overmolded with an insulating material, such as plastic to provide a surface mount IC component, for example, can have leads, e.g. SO-package or other) or no leads, e.g. QFN, DFN, etc., as shown in FIG. 5.

As described above, the first and second capacitors C1, C2 provide an isolated signal path between the first and second die. Communication across the voltage domain barrier can be provided through capacitive coupling in a vertical direction or a combination of vertical and horizontal coupling, e.g., MOM (metal-oxide-metal) capacitors.

The capacitor C1 can exploit lateral capacitive effects fanned between the two or more wiring lines and also by a combination of lateral and vertical capacitive coupling. Lateral capacitive coupling provides high capacitance density per unit of area and at the same time, as process technology shrinks better matching characteristics than vertical coupling due to better process control of lateral dimensions than layer thickness.

In embodiments, active circuit devices are not placed in a keep-out area around the capacitors in the first and second voltage domains. In some embodiments, the keep-out area is defined by an arc spanning the top capacitor plate 214. In other embodiments, the keep-out area is defined by an arc spanning the top capacitor plate 214 and including a shield, in all metal layers, outside the defined keep-out area.

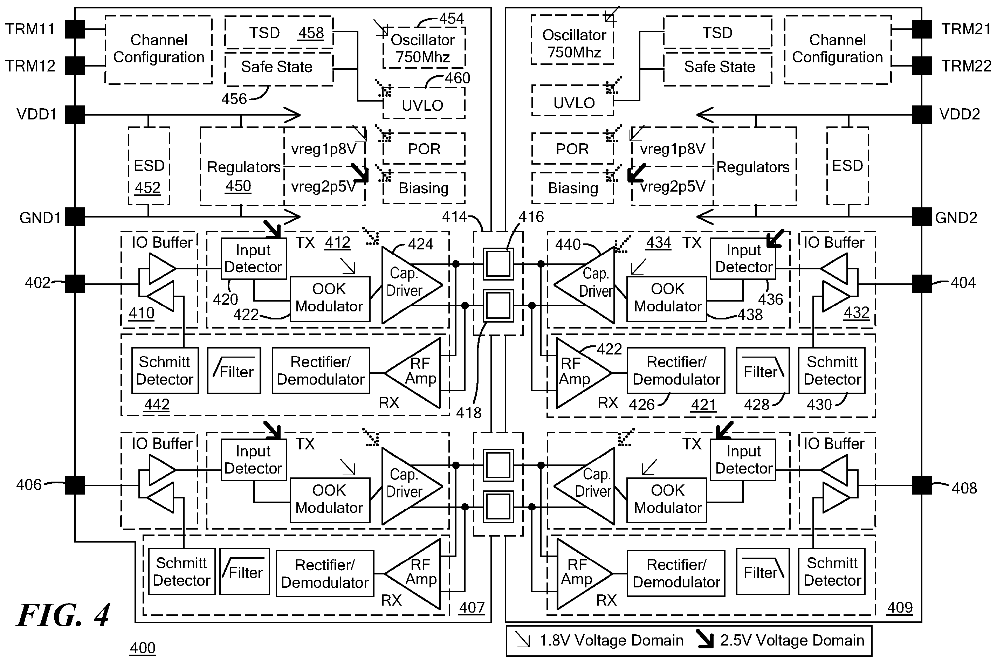

FIG. 4 shows an example single chip isolator implementation 400 in accordance with example embodiments of the invention. A first IO pin 402 and a second IO pin 404 provide a first isolated data path through the isolator 400. A third IO pin 406 and a fourth IO pin 408 provide a second isolated data path through the isolator 400. In the illustrated embodiment, the paths through the isolator are bidirectional. In other embodiments, signals paths have a single direction. The single chip isolator 400 includes a first die portion 407 for a first voltage domain and a second die portion 409 for a second voltage domain.

A first buffer 410, which can be bidirectional as shown, is coupled to the first IO pin 402. A first transmit module 412 is coupled between the first IO pin 402 and an isolated signal coupling device 414, such as a capacitively coupled structure as shown in FIG. 2A. In the illustrated embodiment, the signal coupling device 414 includes first and second capacitively coupled capacitors 416, 418 that provide a differential signal path. The first transmit module 412 can include an input detector 420 coupled to a signal modulator 422, which is coupled to a driver 424. In embodiments, the signal driver 424 generates the differential signal coupled to the isolated signal coupling device 414.

It is understood that a variety of modulation schemes can be used to transmit data across a voltage barrier from the first die 407 to the second die 409 and vice versa. In one embodiment, On-Off keying (OOK) modulation is used. OOK modulation refers to a type of amplitude-shift-keying (ASK) modulation in which the presence or absence of a carrier signal represents digital data. For example, the presence of the carrier signal can represent a ONE and the absence of the carrier signal can represent a ZERO.

On the second die portion 409, a first receive module 421 has an amplifier 422 to receive the differential signal from the first and second capacitively coupled devices 416, 418. The amplifier output can be demodulated 426 and filtered 428. A signal detector 430, such as a Schmidt detector, can be coupled to a second buffer 432 for outputting a signal on the second IO pin 404.

In the case wherein the isolator 400 receives an input signal on the second IO pin 404 for output on the first IO pin 402, the second buffer 432 receives the signals and provides it to a second transmit module 434 located on the second die portion 409. Like the first transmit module 412, the second transmit module 434 includes an input detector 436, a modulator 438, and driver 440 for transmitting the signal across the first and second capacitively coupled devices 416, 418 to a second receive module 442. The first buffer 410 outputs the signal on the first IO pin 402. Similar bidirectional paths are provided between the third and fourth IO pins 406, 408.

In example embodiments, the first die portion 407 is configured to receive a first voltage supply signal VDD1 and ground GND1 for connection to a voltage regulator 450 providing first and second voltage signals, such as 1.8V and 2.5 V to various circuitry on the first die portion. An ESD module 452 can provide electrostatic discharge protection. The first die portion 407 can have first and second control IO pins TRM11, TRM121 for controlling the paths through the isolator. For example, the first and second IO pins TRM11, TRM12 may configure the transmit and receive modules 412, 442 on the first die portion 407 for receiving or outputting a signal on the first IO pin 402 and the third IO pin 406. The first die portion 407 can also include an oscillator 454 for generating clock signals or other periodic signals needed on the first die portion 407.

In a similar arrangement as that described above in conjunction with the first die portion 407, the second die portion 409 is configured to be coupled to a separate second voltage supply VDD2 and ground GND2, along with separate control signals TRM21, TRM22.

The first die portion 407 can include a safe state module 456 for detecting correct OOK modulation, for example. The lack of signal transmission of the carrier frequency signal corresponds to an output safe-state, which avoids a condition in which an application can cause a system fault. The lack of carrier signal signal transmission could be due to any type of error in the internal circuits.

A thermal shutdown module 458 can monitor temperature and generate alerts and an under-voltage-lock-out (UVLO) module 460 can monitor voltage levels in the first die portion 407. If the thermal shutdown module 458 or UVLO module generate an alert in the first die portion 407 the IO pins 402, 406 to go to a high impedance state. Similar functionality can be provided on the second die portion 409 to control IO pins 404, 408. In addition, transmitter modules 412 (434 in the second die portion) can stop transmission to any other domain if a safety-related alert is detected in the die portion. The corresponding channel in the other domain will then be put into the safe state, due to the lack of signal transmission.

In embodiments, the receiver modules 421 comprise C-element (e.g., a type of asynchronous flip-flop) having a differential latch circuit plus a post-filter/integrator for improved immunity to high-frequency transient noise. In some embodiments, the receiver module can include a square function amplifier for power rectification and coupled to a post-filter/integrator for improved immunity to unwanted high frequency transient noise. One or multiple comparators with fixed or time variant thresholds in conjunction with the postfilter/ integrator sets the depth of filtering or the level of immunity to the transient noise.

In other embodiments, the receiver module 421 comprises an RF amplifier 422 to provide amplification of the differential signal and at the same time provide common mode rejection for improving common mode transient noise performance. The RF amplifier can be coupled to a rectifier / demodulator circuit 426, that could be implemented as a diode-based half or full wave rectifier or using any other active implementation, e.g. and square amplifier circuit. The rectifier / demodulator 426 is coupled to a back-end filter / integrator 428 for providing some extra level of immunity to any unwanted high frequency transient noises coupled into the signal path. One or multiple comparators 430 with fixed or time variant thresholds provides a means of digitalization of the transmitted signal.

In embodiments, a desired breakdown insulation capability can be achieved by employing multiple stacked IMD layers on a single capacitor and/or employing a lower count of IMD layers and connecting multiple capacitors in series. This allows flexibility in the selection of the number of metallic layers, the thickness of the IMD layers, and the footprint of the communication channels.

FIG. 5 shows an example pin out for a single-chip isolator 500 having first and second die portions 502, 504, which are electrically isolated from each other to provide first and second voltage domains. As can be seen, the first die portion 502 includes first and second IO pins, shown as pin 2 and pin 3, voltage supply VDD1 pin 1 and ground pin 4. The second die portion 504 includes IO pins 6 and 7, VDD2 pin 8, and ground pin 5.

It is understood that die portions can have any combination of drivers and receivers and each driver and receiver data transmission channel can share signal processing, routing, and diagnostic features or have such features for each individual data channel. In embodiments, outputs can be in buffered with a push-pull, open drain or other such output driver, or other suitable configurations.

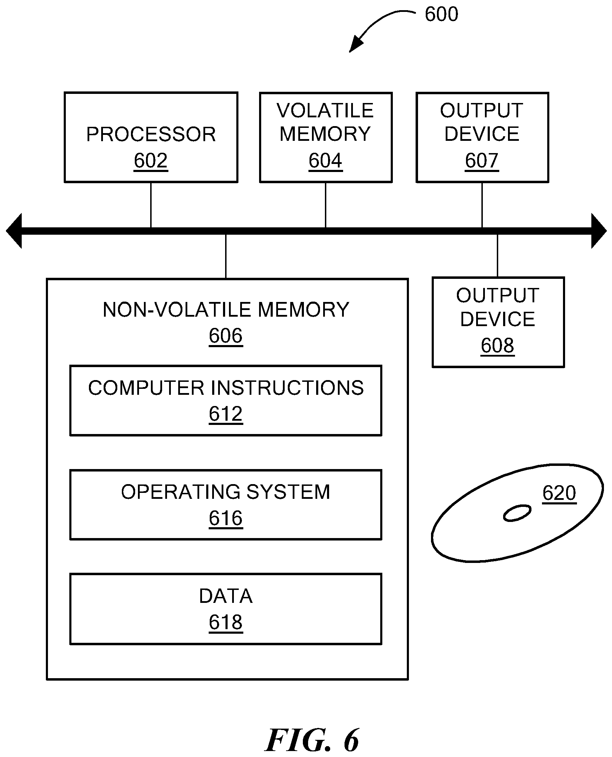

FIG. 6 shows an exemplary computer 600 that can perform at least part of the processing described herein. The computer 600 includes a processor 602, a volatile memory 604, a non-volatile memory 606 (e.g., hard disk), an output device 607 and a graphical user interface (GUI) 608 (e.g., a mouse, a keyboard, a display, for example). The non-volatile memory 606 stores computer instructions 612, an operating system 616 and data 618. In one example, the computer instructions 612 are executed by the processor 602 out of volatile memory 604. In one embodiment, an article 620 comprises non-transitory computer-readable instructions.

Processing may be implemented in hardware, software, or a combination of the two. Processing may be implemented in computer programs executed on programmable computers/machines that each includes a processor, a storage medium or other article of manufacture that is readable by the processor (including volatile and non-volatile memory and/or storage elements), at least one input device, and one or more output devices. Program code may be applied to data entered using an input device to perform processing and to generate output information.

The system can perform processing, at least in part, via a computer program product, (e.g., in a machine-readable storage device), for execution by, or to control the operation of, data processing apparatus (e.g., a programmable processor, a computer, or multiple computers). Each such program may be implemented in a high level procedural or object-oriented programming language to communicate with a computer system. However, the programs may be implemented in assembly or machine language. The language may be a compiled or an interpreted language and it may be deployed in any form, including as a stand-alone program or as a module, component, subroutine, or other unit suitable for use in a computing environment. A computer program may be deployed to be executed on one computer or on multiple computers at one site or distributed across multiple sites and interconnected by a communication network. A computer program may be stored on a storage medium or device (e.g., CD-ROM, hard disk, or magnetic diskette) that is readable by a general or special purpose programmable computer for configuring and operating the computer when the storage medium or device is read by the computer. Processing may also be implemented as a machine-readable storage medium, configured with a computer program, where upon execution, instructions in the computer program cause the computer to operate.

Processing may be performed by one or more programmable processors executing one or more computer programs to perform the functions of the system. All or part of the system may be implemented as, special purpose logic circuitry (e.g., an FPGA (field programmable gate array) and/or an ASIC (application-specific integrated circuit)).

## Claims

1. A signal isolator IC package (200), comprising:
a die having a first die portion (202a) and a second die portion (202b), wherein the first and second die portions (202a, 202b) are electrically isolated, wherein the first die portion (202a) is surrounded on six sides by first insulative material and the second die portion (202b) is surrounded on six sides by second insulative material, wherein:
the first die portion (202a) provides a first voltage domain and the second die portion (202b) provides a second voltage domain;
the signal isolator (200) comprises a first signal path between the first die portion (202a) and the second die portion (202b), wherein the first signal path is isolated with respect to the first and second die portions (202a, 202b);
the first path includes first and second capacitors (C1, C2), wherein the first capacitor (C1) comprises first and second plates (210, 214) separated by a first dielectric layer, and the second capacitor (C2) comprises a third plate (212) and the second plate (214); and
the first and second die portions (202a, 202b) have separate voltage supply signals and separate ground connections.

2. A method, comprising:
employing a die for a signal isolator IC package (200), the die having a first die portion (202a) and a second die portion (202b), wherein:
the first and second die portions (202a, 202b) are electrically isolated;
the first die portion (202a) is surrounded on six sides by first insulative material and the second die portion (202b) is surrounded on six sides by second insulative material;
the first die portion (202a) provides a first voltage domain and the second die portion (202b) provides a second voltage domain;
the signal isolator (200) comprises a first signal path between the first die portion (202a) and the second die portion (202b), wherein the first signal path is isolated with respect to the first and second die portions (202a, 202b); and
the first path includes first and second capacitors (C1, C2), wherein the first capacitor (C1) comprises first and second plates (210, 214) separated by a first dielectric layer, and the second capacitor (C2) comprises a third plate (212) and the second plate (214);
the first and second die portions (202a, 202b) have separate voltage supply signals and separate ground connections.

3. The method according to claim 2, or the signal isolator IC package of claim 1, wherein the die comprises a single die processed to provide the first and second die portions.

4. The method according to claim 2, or the signal isolator IC package of claim 1, wherein the first signal path is bi-directional.

5. The method according to claim 2, or the signal isolator IC package of claim 1, wherein the first and second die portions are separated by a trench filled with insulative material.

6. The method according to claim 1, wherein the second plate overlaps the first plate and the third plate.

7. The method according to claim 2, or the signal isolator IC package of claim 1, wherein the first and second die portions are separated on respective four lateral sides by a trench filled with insulating material.

8. The method according to claim 2, or the signal isolator IC package of claim 1, wherein the first signal path includes coils to provide isolated inductive coupling of the first and second die portions.

9. The method according to claim 2, or the signal isolator IC package of claim 1, wherein active circuit devices are not placed within a keep-out area, and wherein the first capacitor comprises first and second plates separated by a first dielectric layer, and the second capacitor comprises a third plate and the second plate, wherein the keep-out area is defined by the second plate.

10. The method according to claim 2, wherein the first die portion includes a safe-state module to detect a lack of carrier signal.

11. The signal isolator IC package according to claim 2, wherein the second plate overlaps the first plate and the third plate.

12. The signal isolator IC package according to claim 11, or the method of claim 6, wherein the first dielectric layer separates the first plate and the second plate.

13. The signal isolator IC package according to claim 1, or the method of claim 2, wherein the first signal path is configured for On-Off keying (OOK) modulation.

14. The signal isolator IC package according to claim 1, wherein the first die portion includes a safe-state module to detect a lack of carrier signal.

15. The signal isolator IC package according to claim 14, or the method of claim 10, wherein the safe-state module transitions one or more output pins of the IC package to a high impedance state upon detection of an error condition.

## Patentansprüche

1. Signalisolator-IC-Package (200), umfassend:
ein Die mit einem ersten Die-Abschnitt (202a) und einem zweiten Die-Abschnitt (202b), wobei der erste und der zweite Die-Abschnitt (202a, 202b) elektrisch isoliert sind, wobei der erste Die-Abschnitt (202a) auf sechs Seiten durch ein erstes isolierendes Material umgeben ist und der zweite Die-Abschnitt (202b) auf sechs Seiten durch ein zweites isolierendes Material umgeben ist, wobei:
der erste Die-Abschnitt (202a) einen ersten Spannungsbereich bereitstellt und der zweite Die-Abschnitt (202b) einen zweiten Spannungsbereich bereitstellt;
der Signalisolator (200) einen ersten Signalpfad zwischen dem ersten Die-Abschnitt (202a) und dem zweiten Die-Abschnitt (202b) umfasst, wobei der erste Signalpfad in Bezug auf den ersten und den zweiten Die-Abschnitt (202a, 202b) isoliert ist;
der erste Pfad einen ersten und einen zweiten Kondensator (C1, C2) enthält, wobei der erste Kondensator (C1) eine erste und eine zweite Platte (210, 214) umfasst, die durch eine erste dielektrische Schicht getrennt sind, und der zweite Kondensator (C2) eine dritte Platte (212) und die zweite Platte (214) umfasst; und
der erste und der zweite Die-Abschnitt (202a, 202b) separate Spannungsversorgungssignale und separate Erdungsanschlüsse aufweisen.

2. Verfahren, umfassend:
Verwenden eines Dies für ein Signalisolator-IC-Package (200), wobei das Die einen ersten Die-Abschnitt (202a) und einen zweiten Die-Abschnitt (202b) aufweist, wobei:
der erste und der zweite Die-Abschnitt (202a, 202b) elektrisch isoliert sind;
der erste Die-Abschnitt (202a) auf sechs Seiten durch ein erstes isolierendes Material umgeben ist und der zweite Die-Abschnitt (202b) auf sechs Seiten durch ein zweites isolierendes Material umgeben ist;
der erste Die-Abschnitt (202a) einen ersten Spannungsbereich bereitstellt und der zweite Die-Abschnitt (202b) einen zweiten Spannungsbereich bereitstellt;
der Signalisolator (200) einen ersten Signalpfad zwischen dem ersten Die-Abschnitt (202a) und dem zweiten Die-Abschnitt (202b) umfasst, wobei der erste Signalpfad in Bezug auf den ersten und den zweiten Die-Abschnitt (202a, 202b) isoliert ist; und
der erste Pfad einen ersten und einen zweiten Kondensator (C1, C2) enthält, wobei der erste Kondensator (C1) eine erste und eine zweite Platte (210, 214) umfasst, die durch eine erste dielektrische Schicht getrennt sind, und der zweite Kondensator (C2) eine dritte Platte (212) und die zweite Platte (214) umfasst;
der erste und der zweite Die-Abschnitt (202a, 202b) separate Spannungsversorgungssignale und separate Erdungsanschlüsse aufweisen.

3. Verfahren nach Anspruch 2 oder Signalisolator-IC-Package nach Anspruch 1, wobei das Die ein einzelnes Die umfasst, das bearbeitet ist, sodass es den ersten und den zweiten Die-Abschnitt bereitstellt.

4. Verfahren nach Anspruch 2 oder Signalisolator-IC-Package nach Anspruch 1, wobei der erste Signalpfad bidirektional ist.

5. Verfahren nach Anspruch 2 oder Signalisolator-IC-Package nach Anspruch 1, wobei der erste und der zweite Die-Abschnitt durch einen mit isolierendem Material gefüllten Graben getrennt sind.

6. Verfahren nach Anspruch 1, wobei die zweite Platte die erste Platte und die dritte Platte überlappt.

7. Verfahren nach Anspruch 2 oder Signalisolator-IC-Package nach Anspruch 1, wobei der erste und der zweite Die-Abschnitt an jeweiligen vier lateralen Seiten durch einen mit Isoliermaterial gefüllten Graben getrennt sind.

8. Verfahren nach Anspruch 2 oder Signalisolator-IC-Package nach Anspruch 1, wobei der erste Signalpfad Spulen enthält, um eine isolierte induktive Kopplung des ersten und des zweiten Die-Abschnitts bereitzustellen.

9. Verfahren nach Anspruch 2 oder Signalisolator-IC-Package nach Anspruch 1, wobei aktive Schaltkreisvorrichtungen nicht innerhalb eines Verbotsbereichs angeordnet sind und wobei der erste Kondensator eine erste und eine zweite Platte umfasst, die durch eine erste dielektrische Schicht getrennt sind, und der zweite Kondensator eine dritte Platte und die zweite Platte umfasst, wobei der Verbotsbereich durch die zweite Platte definiert ist.

10. Verfahren nach Anspruch 2, wobei der erste Die-Abschnitt ein Safe-State-Modul enthält, um einen Mangel an Trägersignal zu erkennen.

11. Signalisolator-IC-Package nach Anspruch 2, wobei die zweite Platte die erste Platte und die dritte Platte überlappt.

12. Signalisolator-IC-Package nach Anspruch 11 oder Verfahren nach Anspruch 6, wobei die erste dielektrische Schicht die erste Platte und die zweite Platte trennt.

13. Signalisolator-IC-Package nach Anspruch 1 oder Verfahren nach Anspruch 2, wobei der erste Signalpfad für eine On-Off-Keying(OOK)-Modulation konfiguriert ist.

14. Signalisolator-IC-Package nach Anspruch 1, wobei der erste Die-Abschnitt ein Safe-State-Modul enthält, um einen Mangel an Trägersignal zu erkennen.

15. Signalisolator-IC-Package nach Anspruch 14 oder Verfahren nach Anspruch 10, wobei das Safe-State-Modul einen oder mehrere Ausgangspins des IC-Package bei Erkennung einer Fehlerbedingung in einen Zustand mit hoher Impedanz überführt.

## Revendications

1. Boîtier de CI (200) d'isolateur de signal, comprenant :
une puce comportant une première partie (202a) de puce et une seconde partie (202b) de puce, lesdites première et seconde parties (202a, 202b) de puce étant électriquement isolées, ladite première partie (202a) de puce étant entourée sur six côtés par un premier matériau isolant et ladite seconde partie (202b) de puce étant entourée sur six côtés par un second matériau isolant,
ladite première partie (202a) de puce fournissant un premier domaine de tension et ladite seconde partie (202b) de puce fournissant un second domaine de tension ;
ledit isolateur de signal (200) comprenant un premier trajet de signal entre la première partie (202a) de puce et la seconde partie (202b) de puce, ledit premier trajet de signal étant isolé par rapport aux première et seconde parties (202a, 202b) de puce ;
ledit premier trajet comprenant des premier et second condensateurs (C1, C2), ledit premier condensateur (C1) comprenant des première et deuxième plaques (210, 214) séparées par une première couche diélectrique, et ledit second condensateur (C2) comprenant une troisième plaque (212) et la deuxième plaque (214) ; et
lesdites première et seconde parties (202a, 202b) de puce comportant des signaux d'alimentation en tension séparés et des connexions de masse séparées.

2. Procédé, comprenant :
l'emploi d'une puce pour un boîtier de CI (200) d'isolateur de signal, la puce comportant une première partie (202a) de puce et une seconde partie (202b) de puce,
lesdites première et seconde parties (202a, 202b) de puce étant électriquement isolées ;
ladite première partie (202a) de puce étant entourée sur six côtés par un premier matériau isolant et ladite seconde partie (202b) de puce étant entourée sur six côtés par un second matériau isolant ;
ladite première partie (202a) de puce fournissant un premier domaine de tension et ladite seconde partie (202b) de puce fournissant un second domaine de tension ;
ledit isolateur de signal (200) comprenant un premier trajet de signal entre la première partie (202a) de puce et la seconde partie (202b) de puce, ledit premier trajet de signal étant isolé par rapport aux première et seconde parties (202a, 202b) de puce ; et
ledit premier trajet comprenant des premier et second condensateurs (C1, C2), ledit premier condensateur (C1) comprenant des première et deuxième plaques (210, 214) séparées par une première couche diélectrique, et ledit second condensateur (C2) comprenant une troisième plaque (212) et la deuxième plaque (214) ;
lesdites première et seconde parties (202a, 202b) de puce comportant des signaux d'alimentation en tension séparés et des connexions de masse séparées.

3. Procédé selon la revendication 2, ou boîtier de CI d'isolateur de signal de la revendication 1, ladite puce comprenant une puce unique traitée pour fournir les première et seconde parties de puce.

4. Procédé selon la revendication 2, ou boîtier de CI d'isolateur de signal de la revendication 1, ledit premier trajet de signal étant bidirectionnel.

5. Procédé selon la revendication 2, ou boîtier de CI d'isolateur de signal de la revendication 1, lesdites première et seconde parties de puce étant séparées par une tranchée remplie de matériau isolant.

6. Procédé selon la revendication 1, ladite deuxième plaque chevauchant ladite première plaque et ladite troisième plaque.

7. Procédé selon la revendication 2, ou boîtier de CI d'isolateur de signal de la revendication 1, lesdites première et seconde parties de puce étant séparées sur quatre côtés latéraux respectifs par une tranchée remplie de matériau isolant.

8. Procédé selon la revendication 2, ou boîtier de CI d'isolateur de signal de la revendication 1, ledit premier trajet de signal comprenant des bobines pour fournir un couplage inductif isolé des première et seconde parties de puce.

9. Procédé selon la revendication 2, ou boîtier de CI d'isolateur de signal de la revendication 1, des dispositifs de circuit actif n'étant pas placés à l'intérieur d'une zone d'exclusion, et ledit premier condensateur comprenant des première et deuxième plaques séparées par une première couche diélectrique, et ledit second condensateur comprenant une troisième plaque et la deuxième plaque, ladite zone d'exclusion étant définie par la deuxième plaque.

10. Procédé selon la revendication 2, ladite première partie de puce comprenant un module de mise en sécurité pour détecter un manque de signal de porteuse.

11. Boîtier de CI d'isolateur de signal selon la revendication 2, ladite deuxième plaque chevauchant ladite première plaque et ladite troisième plaque.

12. Boîtier de CI d'isolateur de signal selon la revendication 11, ou procédé de la revendication 6, ladite première couche diélectrique séparant la première plaque et la deuxième plaque.

13. Boîtier de CI d'isolateur de signal selon la revendication 1, ou procédé de la revendication 2, ledit premier trajet de signal étant configuré pour une modulation par modulation tout ou rien (OOK).

14. Boîtier de CI d'isolateur de signal selon la revendication 1, ladite première partie de puce comprenant un module de mise en sécurité pour détecter un manque de signal de porteuse.

15. Boîtier de CI d'isolateur de signal selon la revendication 14, ou procédé de la revendication 10, ledit module de mise en sécurité faisant passer une ou plusieurs broches de sortie du boîtier de CI à un état d'impédance élevée lors de la détection d'une condition d'erreur.
